(19) Europäisches Patentamt
European Patent Office
Office européen des brevets

(11) **EP 1 399 606 B1**

(12) **FASCICULE DE BREVET EUROPEEN**

(45) Date de publication et mention
de la délivrance du brevet:
**31.08.2005 Bulletin 2005/35**

(21) Numéro de dépôt: **02758518.1**

(22) Date de dépôt: **25.06.2002**

(51) Int Cl.$^7$: **C30B 11/00**

(86) Numéro de dépôt international:
**PCT/FR2002/002192**

(87) Numéro de publication internationale:
**WO 2003/000961 (03.01.2003 Gazette 2003/01)**

(54) **DISPOSITIF DE FABRICATION DE CRISTAUX D'ALLIAGE**

VORRICHTUNG ZUR HERSTELLUNG VON LEGIERUNGSKRISTALLEN

DEVICE FOR PRODUCING ALLOY CRYSTALS

(84) Etats contractants désignés:
**DE GB IT**

(30) Priorité: **26.06.2001 FR 0108402**

(43) Date de publication de la demande:
**24.03.2004 Bulletin 2004/13**

(73) Titulaire: **COMMISSARIAT A L'ENERGIE ATOMIQUE**
**75752 Paris 15ème (FR)**

(72) Inventeur: **PETROZ, Gérard**
**F-38330 MONTBONNOT (FR)**

(74) Mandataire: **Poulin, Gérard et al**
**Société BREVATOME**
**3, rue du Docteur Lancereaux**
**75008 Paris (FR)**

(56) Documents cités:
**US-A- 4 264 406**     **US-A- 4 551 196**
**US-A- 4 980 133**

• **ASAHI ET AL: "Growth and characterization of 100 mm diameter CdZnTe single crystals by the vertical gradient freezing method" JOURNAL OF CRYSTAL GROWTH., vol. 161, 1996, pages 20-27, XP004017359 NORTH-HOLLAND PUBLISHING CO. AMSTERDAM., NL ISSN: 0022-0248 cité dans la demande**
• **PATENT ABSTRACTS OF JAPAN vol. 2000, no. 08, 6 octobre 2000 (2000-10-06) & JP 2000 143385 A (SUMITOMO ELECTRIC IND LTD), 23 mai 2000 (2000-05-23)**
• **PATENT ABSTRACTS OF JAPAN vol. 014, no. 531 (C-0780), 21 novembre 1990 (1990-11-21) & JP 02 221180 A (FUYUUTEC FUAANESU:KK), 4 septembre 1990 (1990-09-04)**

**Description**

**DOMAINE TECHNIQUE**

La présente invention concerne un dispositif de fabrication de cristaux d'alliage par refroidissement et solidification contrôlée d'un matériau liquide.

Elle concerne en particulier la fabrication de cristaux de semiconducteurs composés (binaires, ternaires, etc.) des familles III-V ou II-VI où l'homogénéité de composition associée à la qualité cristalline permet d'atteindre les spécifications et les performances de l'application envisagée. On peut citer à titre d'exemple le CdZnTe utilisé comme substrat en détection infrarouge ou comme matériau détecteur des rayonnements ionisants (rayons X, y, etc).

Dans ces deux applications, l'homogénéité de la composition chimique, et en particulier le pourcentage de Zn, est capitale parce que, dans un cas, il permet d'adapter le paramètre de maille à celui d'une couche mince active déposée par épitaxie et, dans un autre cas, il participe directement à la détection.

**ETAT DE LA TECHNIQUE ANTERIEURE**

Il est bien connu qu'au cours de la solidification d'un alliage, la concentration de ces constituants (ou des impuretés qui s'y trouvent varie le long du lingot. Cette concentration suit en général la relation suivante appelée relation de Pfann :

$$C = C_0 k(l - f)^{k-1}$$

     f étant la fraction du lingot solidifié,
     C étant la concentration en f,
     $C_0$ étant la concentration en f = 0,
     k étant le coefficient de ségrégation.

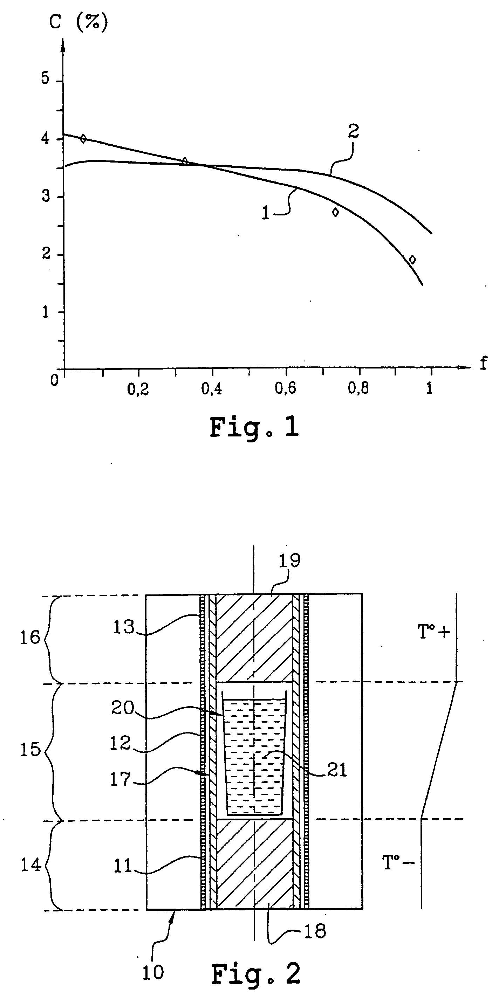

Dans le cas de l'alliage CdZnTe, le coefficient k pour l'élément Zn vaut 1,3 ce qui signifie que le pourcentage de Zn varie du simple au double le long du lingot. C'est ce que montre le diagramme de la figure 1.

Pour ce diagramme, l'axe des ordonnées représente la concentration C de Zn dans l'alliage et l'axe des abscisses représente la fraction f du lingot solidifié. La courbe 1 montre l'évolution de la concentration de Zn selon la relation de Pfann.

Dans le cas de certaines impuretés à faible concentration, un traitement thermique adapté permet, par diffusion, d'homogénéiser le taux d'impuretés dans un alliage ou un matériau. Cependant, cette méthode ne peut pas s'appliquer pour les constituants d'alliages dont les taux peuvent atteindre 25%.

Une autre solution connue pour tenter de remédier à ce problème consiste, dans certains cas, à ajouter à l'alliage un élément dont le coefficient de ségrégation est opposé à celui de l'élément dont on veut stabiliser le taux. Par exemple, dans le cas de CdZnTe, il est possible d'ajouter l'élément Se dont le coefficient de ségrégation vaut 0,9. Ceci permet en effet d'homogénéiser la valeur du paramètre de maille sur le lingot, mais la présence de cet élément a des conséquences néfastes sur une couche active déposée par épitaxie.

L'article « Growth and characterization of 100 mm diameter CdZnTe single crystals by the vertical gradient freezing method » de T. ASAHI et al., paru dans Journal of Crystal Growth 161 (1996), pages 20-27, divulgue un procédé de croissance d'un cristal de CdZnTe dans un four comportant plusieurs zones de chauffage dont les températures sont contrôlées indépendamment. Le matériau à cristalliser se trouve dans une ampoule de quartz qui reste fixe au centre du four. Ce procédé de croissance ne fournit cependant pas de lingots homogènes et monocristallins.

Il se pose donc le problème de réduire la ségrégation de certains constituants d'un alliage afin d'améliorer l'homogénéité de composition dans le cas d'une solidification lente et contrôlée et de garantir une qualité cristallographique ou des propriétés spécifiques homogènes.

Le document US-A-4 980 133 divulgue un dispositif de fabrication de cristaux à croissance contrôlée. Le dispositif comprend deux tubes chauffants disposés en alignement et séparés par un manchon conducteur. Les tubes chauffants imposent deux zones de températures différentes tandis que le manchon conducteur assure une zone de gradient thermique entre les tubes chauffants. La croissance du cristal se fait dans une ampoule comprenant le matériau à cristalliser. La cristallisation s'obtient en faisant descendre l'ampoule de la zone supérieure plus chaude vers la zone inférieure plus froide.

Le document US-A-4 264 406 divulgue un procédé de croissance cristalline. Le procédé comprend les étapes consistant à :

-   disposer un creuset contenant le matériau à cristalliser à proximité de la paroi chauffante d'un four, le creuset demeurant fixe par rapport à la paroi chauffante durant les phases de chauffage et de refroidissement,

-   maintenir la température de la paroi chauffante au-dessus du point de fusion du matériau,

-   introduire progressivement un écran entre le creuset et la paroi chauffante, l'écran permettant le refroidissement du cristal.

**EXPOSÉ DE L'INVENTION**

La qualité du lingot étant directement liée au gradient de température auquel est soumis le matériau liquide à solidifier, le point de cristallisation doit avancer très régulièrement au fur et à mesure que le cristal grandit. Pour cela, il est proposé selon la présente invention de placer autour du matériau liquide un tube réalisé en un matériau très bon conducteur thermique.

Le dispositif selon l'invention présente l'avantage de n'imposer aucun déplacement de l'ampoule ou du creuset contenant le matériau, ou encore du four. Il est donc associé à un procédé simple et très souple dans ses applications, notamment la forme du gradient.

L'invention a donc pour objet un dispositif de fabrication de cristaux d'alliage par refroidissement et solidification contrôlée d'un matériau liquide comprenant les constituants de l'alliage, comprenant un four pourvu de moyens de chauffage permettant de rendre liquide ledit matériau puis de le refroidir jusqu'à obtenir progressivement sa solidification, le dispositif comprenant aussi des moyens de réception dudit matériau disposés dans le four, caractérisé en ce que :

- les moyens de chauffage comprennent trois éléments chauffants fournissant trois zones de chauffage juxtaposées : une zone dite chaude, une zone intermédiaire dite à gradient de température et une zone dite froide, la zone intermédiaire étant comprise entre la zone froide et la zone chaude,
- les moyens de réception sont fixes par rapport au four et sont situés de façon que le matériau se trouve dans la zone intermédiaire,
- des moyens thermiquement conducteurs sont disposés entre les moyens de réception et les moyens de chauffage et s'étendent depuis la zone froide jusqu'à la zone chaude.

Avantageusement, les moyens de chauffage sont des moyens de chauffage électrique.

Selon un mode de réalisation préférentiel, le four est un four vertical, les trois zones de chauffage étant superposées. La zone chaude peut être située audessus de la zone intermédiaire, la zone froide étant alors située en dessous de la zone intermédiaire.

Si le four et les moyens de réception sont de forme cylindrique, les moyens thermiquement conducteurs peuvent être constitués par un tubé. Avantageusement, ce tube est un tube d'épaisseur constante.

De préférence, les moyens thermiquement conducteurs sont en un métal choisi parmi le cuivre, l'aluminium et les aciers spéciaux.

**BRÈVE DESCRIPTION DES DESSINS**

L'invention sera mieux comprise et d'autres avantages et particularités apparaîtront à la lecture de la description qui va suivre, donnée à titre d'exemple non limitatif, accompagnée des dessins annexés parmi lesquels :

- le figure 1 est un diagramme représentant l'évolution de la concentration en Zn dans un alliage CdZnTe selon la loi de Pfann pour un lingot selon l'art connu et pour un lingot selon l'invention,
- la figure 2 représente, de manière schématique et en coupe longitudinale, un dispositif de fabrication de cristaux d'alliage selon l'invention,
- la figure 3 est un graphe représentant l'évolution des températures sur le matériau à solidifier, en début et en fin de solidification,
- les figures 4A à 4C sont des graphes représentant des programmes de refroidissement permettant de modifier ou non la vitesse de solidification et le gradient thermique en cours de solidification.

**DESCRIPTION DETAILLEE DE MODES DE RÉALISATION DE L'INVENTION**

La figure 2 représente, en coupe longitudinale, un dispositif de fabrication de cristaux d'alliage selon l'invention. Ce dispositif est de forme générale cylindrique.

Le dispositif comprend un four vertical 10 en forme de cylindre creux. Le trou central du four permet l'introduction d'un creuset 20 comprenant le matériau 21 à cristalliser.

Le four 10 comporte trois éléments chauffants électriques : la bobine 11 située en partie inférieure, la bobine 12 située en partie médiane et la bobine 13 située en partie supérieure. Les bobines 11, 12 et 13 définissent respectivement une zone froide 14, une zone intermédiaire 15 (à gradient de température) et une zone chaude 16.

Un tube 17, très bon conducteur thermique, est disposé dans le trou central du four. Selon les spécificités du matériau à cristalliser, le tube peut être en cuivre, en aluminium ou en acier spécial. Comme le montre la figure 2, le diamètre du creuset 20 est très proche du diamètre intérieur du tube 17.

Dans cet exemple de réalisation, le tube 17 traverse les trois zones de chauffage. Son épaisseur doit être suffisante pour que le transport de calories de la zone chaude vers la zone froide se fasse convenablement.

On remarque que la zone intermédiaire 15 a une hauteur au moins égale à la hauteur de matériau liquide prévue dans le creuset 20.

Le creuset 20 est confiné au centre du four et reste fixe pendant l'opération de solidification lente qui s'effectue de bas en haut dans cet exemple de mise en oeuvre, à une vitesse comprise entre 0,1 et 5 mm/h pour un alliage de type CdZnTe.

Des bouchons 18 et 19 obturent les deux extrémités du trou central du four. Ils se logent dans les parties du trou central correspondant aux zones froide et chaude.

La solidification contrôlée du matériau est obtenue en créant un gradient thermique continu dans la zone intermédiaire 15. Sa valeur moyenne dépend de la différence de température entre les zones supérieure 16 et inférieure 14 du four et de la puissance fournie à la zone intermédiaire 15.

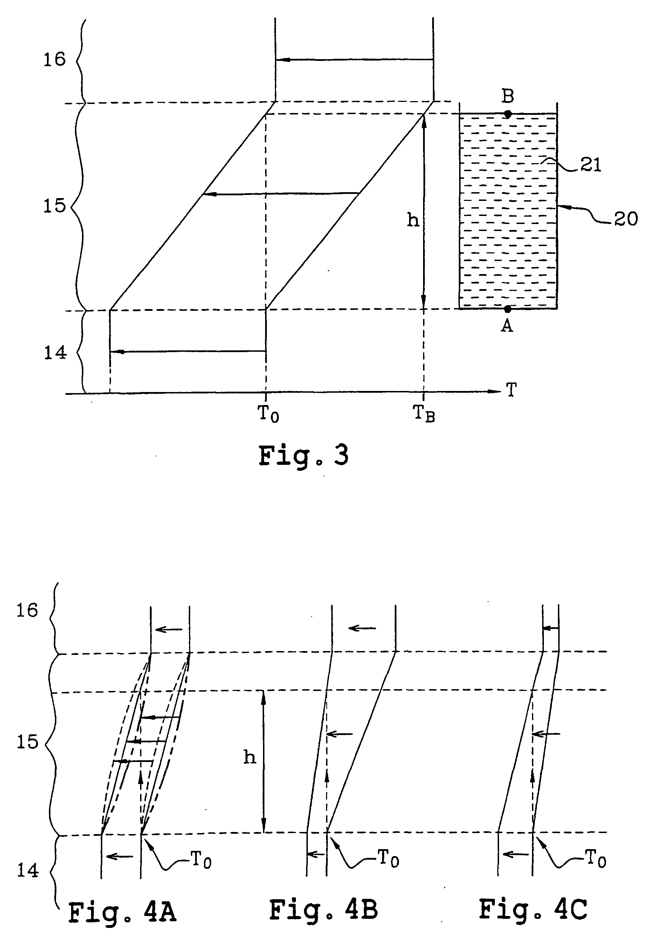

Le déplacement du gradient thermique est obtenu en refroidissant les trois zones convenablement, la limite solide-liquide étant à la température théorique de solidification de l'alliage. La figure 3 illustre le principe de solidification contrôlée mis en oeuvre par l'invention.

La figure 3 montre, sur la partie droite de la figure, le creuset 20 contenant le matériau à cristalliser 21. Sur la partie gauche de la figure et en correspondance avec le creuset représenté en partie droite est placé un graphe représentant l'évolution des températures sur le matériau à cristalliser, en début et en fin de solidification.

Dans cet exemple de mise en oeuvre du procédé selon l'invention, la solidification a lieu de bas en haut mais cette solidification peut aussi être réalisée de haut en bas ou non verticalement.

Au début de la solidification, le point A (à la surface inférieure du matériau) est à la température $T_0$ qui est la température réelle de solidification du matériau. Au point B, situé à la surface du liquide, la température est plus élevée et vaut $T_B$. Le gradient thermique entre les points A et B est $(T_B - T_0)/h$, h étant la hauteur du matériau dans le creuset. Les températures sont reportées sur l'axe des températures T.

La solidification progressive du matériau liquide est obtenue en refroidissant les trois zones 14, 15 et 16. L'ensemble du gradient thermique se déplace au cours de l'opération vers des températures inférieures comme cela est indiqué par les flèches de sorte que, quand la température au point B atteint la valeur $T_0$, la solidification est terminée.

L'invention permet la réalisation et le contrôle de gradients thermiques très continus et précis dans la gamme (par exemple de 0 à 5°C/cm sur 25 cm de longueur) sur l'ensemble du liquide en particulier et donc une action contrôlée sur le régime de convection du liquide, acteur principal de la ségrégation des constituants du matériau.

La courbe 2 de la figure 1 montre, pour un alliage CdZnTe, l'évolution de la concentration en Zn en utilisant le dispositif selon l'invention. On peut remarquer, par comparaison avec la courbe 1, qu'une meilleure homogénéité est obtenue sur 80% du lingot. Le début et la fin du lingot sont écartés parce qu'ils comportent des défauts spécifiques.

Les figures 4A à 4C sont des graphes représentant des programmes de refroidissement permettant de modifier ou non la vitesse de solidification et le gradient thermique en cours de solidification. On a mentionné sur ces figures la hauteur h de matériau à cristalliser.

La figure 4A montre des programmes à vitesse de solidification constante. Le graphe en trait plein correspond à un gradient thermique constant. Il est similaire à celui de la figure 3. Le graphe en traits mixtes correspond à un gradient thermique décroissant. Le graphe en traits interrompus correspond à un gradient thermique croissant.

La figure 4B montre un graphe correspondant à un programme à vitesse de solidification croissante et à gradient thermique décroissant.

La figure 4C montre un graphe correspondant à un programme à vitesse de solidification décroissante et à gradient thermique croissant.

On sait qu'en cristallogenèse la moindre variation de température peut avoir des conséquences directes et néfastes sur la qualité des lingots fabriqués puisqu'elle agit directement sur la vitesse de solidification qui, si elle n'est pas continue, génère des défauts et des variations de ségrégation des espèces. Le dispositif selon l'invention remédie à ces risques pour les raisons suivantes :

- le creuset contenant le matériau est fixe et très confiné dans le four, ce qui a pour conséquence une absence de vibrations et pas d'effet de cheminée pour les gaz environnants ;
- les moyens thermiquement conducteurs traversant le four homogénéisent au mieux la puissance thermique générée par les moyens de chauffage du four, à la fois radialement et longitudinalement ;
- la masse de ces moyens thermiquement conducteurs peut absorber de petites variations de température sans conséquence majeure sur la croissance du solide ;
- la géométrie de ces moyens thermiquement conducteurs (tube cylindrique d'épaisseur constante par exemple) permet la réalisation d'un gradient thermique linéaire, ou au contraire non linéaire, mais très continu. (Si on le souhaite, cette souplesse permet de faire varier de manière continue la vitesse de solidification le long du lingot et donc d'agir sur la ségrégation des espèces).

Le dispositif selon l'invention est très simple et économiquement intéressant. Il permet la réalisation de matériaux de grande qualité cristalline (taux de dislocation minimum, perfection du réseau cristallin, effets minimisés de la ségrégation des espèces).

En cas de fuite du creuset ou de réaction des espèces, les moyens thermiquement conducteurs (par exemple un tube) protègent les éléments chauffants du four.

Le dispositif selon l'invention permet en particulier la fabrication de cristaux de CdZnTe destinés à l'optronique. L'homogénéité du taux de Zn est améliorée d'un facteur 1,5 sur un lingot de 90 mm de diamètre et de 100 mm de long. La qualité cristalline du matériau obtenu est très convenable pour l'application envisagée.

**Revendications**

1. Dispositif de fabrication de cristaux d'alliage par refroidissement et solidification contrôlée d'un matériau liquide (21) comprenant les constituants de l'alliage, comprenant un four (10) pourvu de moyens de chauffage (11, 12, 13) permettant de rendre liquide ledit matériau puis de le refroidir jusqu'à obtenir progressivement sa solidification, le dispositif comprenant aussi des moyens de réception (20) dudit matériau disposés dans le four, **caractérisé en ce que** :

-   les moyens de chauffage comprennent trois éléments chauffants fournissant trois zones de chauffage juxtaposées : une zone dite chaude (16), une zone intermédiaire (15) dite à gradient de température et une zone dite froide (14), la zone intermédiaire étant comprise entre la zone froide et la zone chaude,
-   les moyens de réception (20) sont fixes par rapport au four (10) et sont situés de façon que le matériau se trouve dans la zone intermédiaire (15),
-   des moyens thermiquement conducteurs (17) sont disposés entre les moyens de réception (20) et les moyens de chauffage (11, 12, 13) et s'étendent depuis la zone froide (14) jusqu'à la zone chaude (16).

2.  Dispositif selon la revendication 1, **caractérisé en ce que** les moyens de chauffage (11, 12, 13) sont des moyens de chauffage électrique.

3.  Dispositif selon l'une des revendications 1 ou 2, **caractérisé en ce que** le four étant un four vertical, les trois zones de chauffage (14, 15, 16) sont superposées.

4.  Dispositif selon la revendication 3, **caractérisé en ce que** la zone chaude (16) est située au-dessus de la zone intermédiaire (15), la zone froide (14) étant située en dessous de la zone intermédiaire.

5.  Dispositif selon l'une quelconque des revendications 1 à 4, **caractérisé en ce que** le four (10) et les moyens de réception (20) étant de forme cylindrique, les moyens thermiquement conducteurs (17) sont constitués par un tube.

6.  Dispositif selon la revendication 5, **caractérisé en ce que** le tube est un tube d'épaisseur constante.

7.  Dispositif selon l'une quelconque des revendications précédentes, **caractérisé en ce que** les moyens thermiquement conducteurs (17) sont en un métal choisi parmi le cuivre, l'aluminium et les aciers spéciaux.

**Patentansprüche**

1.  Vorrichtung zur Herstellung von Legierungskristallen durch kontrollierte Abkühlung und Erstarrung eines die Bestandteile der Legierung enthaltenden flüssigen Materials (21), einen mit Heizeinrichtungen (11, 12, 13) ausgerüsteten Ofen (10) umfassend, der ermöglicht, das genannte Material zu verflüssigen und dann progressiv bis zu seiner Erstarrung abzukühlen, wobei die Vorrichtung auch in dem Ofen angeordnete Aufnahmeeinrichtungen (20) des genannten Material umfasst, **dadurch gekennzeichnet:**

-   **dass** die Heizeinrichtungen drei Heizelemente für drei aneinandergrenzende Heizzonen umfassen, nämlich eine sogenannte heiße Zone (16), eine sogenannte Zwischenzone (15) mit Temperaturgradient und eine sogenannte kalte Zone (14), wobei die Zwischenzone zwischen der kalten Zone und der heißen Zone enthalten ist,
-   **dass** die Aufnahmeeinrichtungen (20) in Bezug auf den Ofen (10) ortsfest und so angeordnet sind, dass das Material sich in der Zwischenzone (15) befindet,
-   **dass** sich wärmeleitfähige Einrichtungen (17) zwischen den Aufnahmeeinrichtungen (20) und den Heizeinrichtungen (11, 12, 13) befinden und sich von der kalten Zone (14) bis zu warmen Zone (16) erstrecken.

2.  Vorrichtung nach Anspruch 1, **dadurch gekennzeichnet, dass** die Heizeinrichtungen (11, 12, 13) elektrische Heizeinrichtungen sind.

3.  Vorrichtung nach einem der Ansprüche 1 oder 2, **dadurch gekennzeichnet, dass** der Ofen ein vertikaler Ofen ist, wobei die drei Heizzonen (14, 15, 16) übereinander liegen.

4.  Vorrichtung nach Anspruch 3, **dadurch gekennzeichnet, dass** die heiße Zone (16) sich über der Zwischenzone (15) befindet und die kalte Zone (14) sich unter der Zwischenzone befindet.

5.  Vorrichtung nach einem der Ansprüche 1 bis 4, **dadurch gekennzeichnet, dass** der Ofen (10) und die Aufnahmeeinrichtungen (20) von zylindrischer Form sind und die wärmeleitfähigen Einrichtungen (17) durch ein Rohr gebildet werden.

6.  Vorrichtung nach Anspruch 5, **dadurch gekennzeichnet, dass** das Rohr ein Rohr von konstanter Dicke ist.

7.  Vorrichtung nach einem der vorangehenden Ansprüche, **dadurch gekennzeichnet, dass** die wärmeleitfähigen Einrichtungen (17) aus einem unter Kupfer, Aluminium und den Edelstählen ausgewählten Metall sind.

**Claims**

1. A device for producing alloy crystals by cooling and controlled solidification of a liquid material (21) comprising the constituents of the alloy, comprising a furnace (10) provided with heating means (11, 12, 13) allowing said material to be rendered liquid then to be cooled until it progressively solidifies, said device also comprising reception means (20) of said material disposed in the furnace, **characterised in that**:

   - the heating means provide three juxtaposed heating zones: a so-called hot zone (16), a so-called intermediary zone (15) with temperature gradient and a so-called cold zone (14), said intermediary zone being comprised between the cold zone and the hot zone,
   - the reception means (20) are fixed relative to the furnace (10) and are situated such that the material is in the intermediary zone (15),
   - thermally conductive means (17) are disposed between the reception means (20) and the heating means (11, 12, 13) and extend from the cold zone (14) as far as the hot zone (16).

2. The device as claimed in Claim 1, **characterised in that** the heating means (11, 12, 13) are electric heating means

3. The device as claimed in any one of Claims 1 or 2, **characterised in that** since the furnace is a furnace vertical, the three heating zones (14, 15, 16) are superposed.

4. The device as claimed in Claim 3, **characterised in that** the hot zone (16) is located above the intermediary zone (15), said cold zone (14) being located below the intermediary zone.

5. The device as claimed in any one of Claims 1 to 4, **characterised in that** since the furnace (10) and the reception means (20) are cylindrical in shape, the thermally conductive means (17) are constituted by a tube.

6. The device as claimed in Claim 5, **characterised in that** the tube is a tube of constant thickness.

7. The device as claimed in any one of the preceding Claims, **characterised in that** the thermally conductive means (17) are made of a metal selected from among copper, aluminium and special steels.

**Fig. 1**

**Fig. 2**

7

Fig. 3

Fig. 4A          Fig. 4B          Fig. 4C